# EUROPÄISCHE PATENTANMELDUNG

(11) **EP 1 594 160 A1**
(43) Veröffentlichungstag der Anmeldung: **09.11.2005**
(21) Anmeldenummer: 05009534.8
(22) Anmeldetag: 30.04.2005
(51) Int. Cl.: H01L 21/02, H01L 23/64

(54) **Verfahren zur Herstellung einer freihängenden Induktivität auf einem Substrat und entsprechendes Bauelement**

(30) Priorität: 05.05.2004 DE 102004022139
(71) Anmelder: ATMEL Germany GmbH, 74072 Heilbronn (DE)
(72) Erfinder: Joodaki, Mojtaba Dr.-Ing., 81735 München (DE)

(57) **Zusammenfassung**

Die vorliegende Erfindung betrifft ein Bauelement und ein Herstellungsverfahren zur Herstellung eines derartigen Bauelementes, bei welchem die Windungen (6) einer Spiralinduktivität (6, 18) in einer Membran (3) derart eingebettet sind, dass sie über einem vollständig zurückgeätzten Bereich (19, 20) des Substrates (1) für eine Entkopplung der Windungen (6) von dem Substrat (1) frei hängen. Ein weiteres Substrat (13) wird mit der Unterseite des zurückgeätzten Bereiches (19, 20) des prozessierten Substrats (1) derart verbunden, dass ein Hohlbereich für eine Entkopplung der Windungen (6) von dem Substrat (1) entsteht.

## Beschreibung

Die vorliegende Erfindung betrifft ein Verfahren zur Herstellung einer Spiralinduktivität auf einem Substrat und eine nach einem derartigen Verfahren hergestellte Spiralinduktivität bzw. hergestelltes Bauelement.

Die Bauelemente-Modellierung von auf einem Halbleitersubstrat integrierten Bauelementen nimmt mit steigender Betriebsfrequenz eine immer größere Rolle ein, da dann die Leitungseigenschaften, die Reflektionen an Diskontinuitäten, das Überlappen und die Verlustleistungen zunehmen. Somit ist eine Berücksichtigung dieser Effekte in der Modellierung, insbesondere im Hochfrequenzbereich, im allgemeinen unerlässlich. Insbesondere bei einem niederohmigen Substrat, wie beispielsweise einem Silizium-Substrat oder einem Silizium-Germanium-Substrat, ist der parasitäre Einfluss der Substratleitfähigkeit und zusätzlicher Kapazitäten nicht zu vernachlässigen.

Obwohl allgemein auf beliebige Induktivitäten anwendbar, werden die vorliegende Erfindung sowie die ihr zugrunde liegende Problematik in Bezug auf eine Spiralinduktivität näher erläutert.

Auf einem Substrat integrierte Induktivitäten sind wertvolle Bauelemente in Radiofrequenzschaltungen, welche über einen großen Anwendungsbereich, beispielsweise in schnurlosen Kommunikationssystemen, verfügen. Als schnurlose Kommunikationssysteme kommen beispielsweise Personal Communication Services, Wireless Local Area Network, Satelliten-Kommunikationssysteme, GPS-Systeme, etc. in Frage

Ein allgemeines Problem der integrierten Induktivitäten besteht in den relativ niedrigen Qualitätsfaktoren, einer zufriedenstellenden Erdung, abweichenden Charakteristika in Abhängigkeit von der Substratgeometrie, elektromagnetischen Kopplungen zwischen den Induktivitäten und dem Substrat und in relativ niedrigen Eigenresonanzfrequenzen. Die Induktivitäten werden oft als Schmalbandlasten in Radiofrequenzschaltungen, wie beispielsweise Verstärkern, Oszillatoren, oder dergleichen verwendet. Somit finden integrierte Induktivitäten, insbesondere in dem Consumer Electronic-Markt, einen hohen Anwendungsbereich. Allerdings sind Herstellungskosten, Integrationsdichte und Zuverlässigkeit weitere entscheidende Faktoren, welche bei der Herstellung von integrierten Induktivitäten berücksichtigt werden müssen.

Da sich die Technologie im Radiofrequenz-Bereich von großen Systemen mit einer großen Reichweite hin zu kleineren Systemen mit einer geringeren Reichweite verlagert und immer mehr neuere Systeme mobil ausgestaltet werden, geht der Trend in dem RF-Bereich dahin, radiofrequenztaugliche Geräte zu schaffen, welche günstiger und handlicher ausgebildet sind.

Zur Realisierung von integrierten Induktivitäten haben sich in der planaren Schaltungstechnik Spiralinduktivitäten durchgesetzt. Die erzielbaren Induktivitätswerte liegen hierbei in der Größenordnung von 0,1 nH bis 10 nH. Dabei können die Spiralinduktivitäten sowohl runde als auch rechteckige Windungen mit unterschiedlichen Geometrien aufweisen. Die Spiralinduktivitäten spielen eine wichtige Rolle in beispielsweise integrierten Schaltungen im Radiofrequenzbereich, wobei sie häufig als Bauelemente zum Minimieren von Phasengeräuschen, als Induktivitäten mit einer niedrigen Verlustleistung für LNA-Anschlüsse oder als Induktivitäten mit einem geringen elektrischen Widerstand für Verstärkerausgänge, als Lasten, oder als Emitter/Source-Degeneratoren mit vernachlässigbarem Spannungsabfall für Betriebe im Niederspannungsbereich in silizium-basierenden integrierten Schaltungsprozessen dienen.

Allgemein besteht also die Problematik, dass eine Integration von planaren Spiralinduktivitäten auf beispielsweise einem Silizium-Substrat gewöhnlich in Leistungsverlusten bezüglich der Resonanzfrequenz und des Qualitätsfaktors resultiert. Vornehmlich ist die Kopplung zwischen der Spiralinduktivität und seiner Umgebung über das Silizium-Substrat und der Mangel an einer guten Masseebene aufgrund der Substratverluste die Ursache derartiger Nachteile der integrierten Spiralinduktivitäten. Zusätzlich verursacht der magnetische Fluss entlang der Spule, welcher senkrecht in das Substrat hinein gerichtet ist, Substratverluste aufgrund der erzeugten Wirbelströme. Diese Effekte reduzieren ebenfalls den Qualitätsfaktor der integrierten planaren Spiralinduktivität.

Bisher existieren im Stand der Technik mehrere Ansätze zur Integration von Spiralinduktivitäten in ein Silizium-Substrat, wobei eine Erhöhung des Qualitätsfaktors und der Eigenfrequenzresonanz der Induktivitäten auf dem Silizium-Substrat erreicht werden soll.

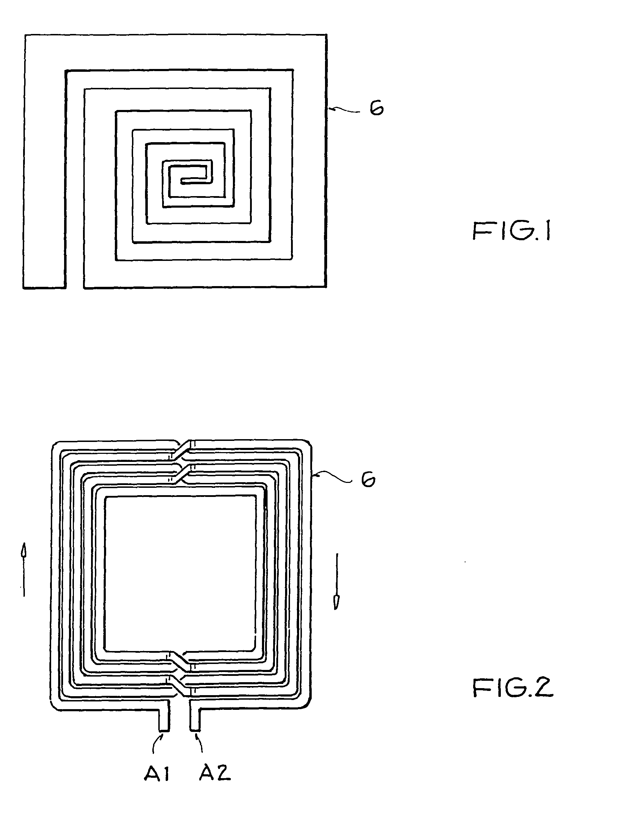

Gemäß einem Ansatz nach dem Stand der Technik wird die Windungsbreite der Windungen der Spiralinduktivität von innen nach außen kontinuierlich erhöht, wie in Fig. 1 dargestellt ist. Dadurch können die magnetischen Verluste der Spiralinduktivität erheblich verringert werden. Dies ist allerdings relativ schwierig zu bewerkstelligen.

Fig. 2 illustriert einen weiteren Ansatz gemäß dem Stand der Technik, wobei zur Erhöhung des Qualitätsfaktors und der Eigenresonanzfrequenz im Vergleich zu einer lediglich ein Ende aufweisenden Induktivität zwei Windungseinheiten zueinander positioniert werden. Die Spannungen und Ströme an den beiden Anschlüssen A1 und A2 sind vorzugsweise um 180° phasenverschoben. Dieser Ansatz weist jedoch den Nachteil auf, dass hohe Kopplungs- bzw. Substratverluste auftreten.

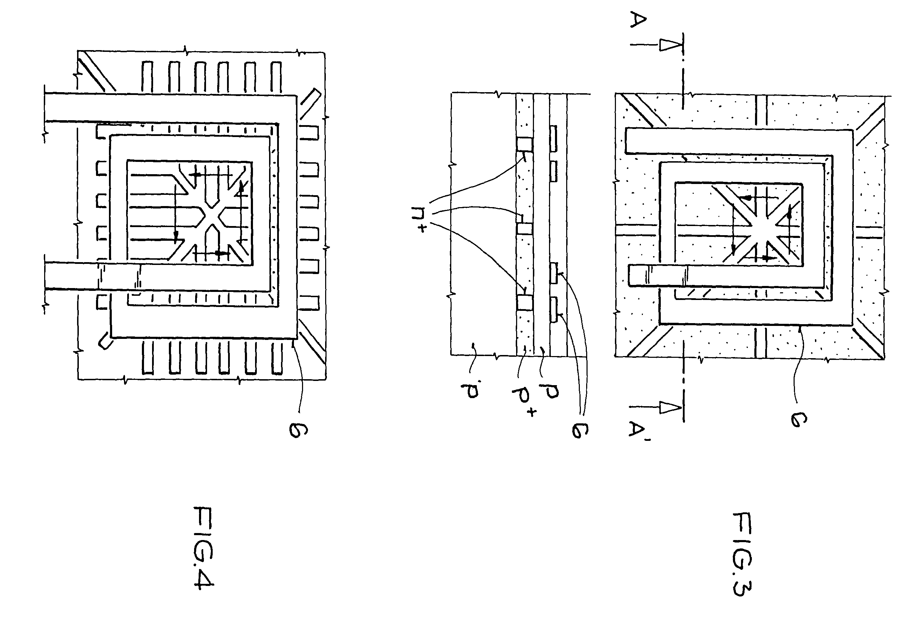

Fig. 3 illustriert einen weiteren Ansatz gemäß dem Stand der Technik zur Schaffung einer integrierten Induktivität, wobei ein p-n-p-Übergang senkrecht zu dem Wirbelstromfluss ausgenutzt wird, um die Substratverluste der integrierten Induktivität 6 zu reduzieren. Die Wirbelströme sind in den Fig. 3 und 4 durch die geschlossen miteinander verbundenen Pfeile gekennzeichnet.

Fig. 4 illustriert einen weiteren Ansatz gemäß dem Stand der Technik, wobei zur Erhöhung des Qualitätsfaktors und zur Minimierung der Substratkopplung eine strukturierte Masseabschirmung zwischen zwei benachbarten Induktivitäten verwendet wird. Die Massemetallisierung ist streifenförmig mit Schlitzen dazwischen angeordnet, welche senkrecht zu der Spiralinduktivität in die Massemetallisierung 5 geätzt sind. Die Breite der Schlitze sollte eng genug sein, um das elektrische Feld daran zu hindern, in das darunter liegende Silizium-Substrat einzudringen. Jedoch wird dazu ein relativ aufwendiges Verfahren benötigt.

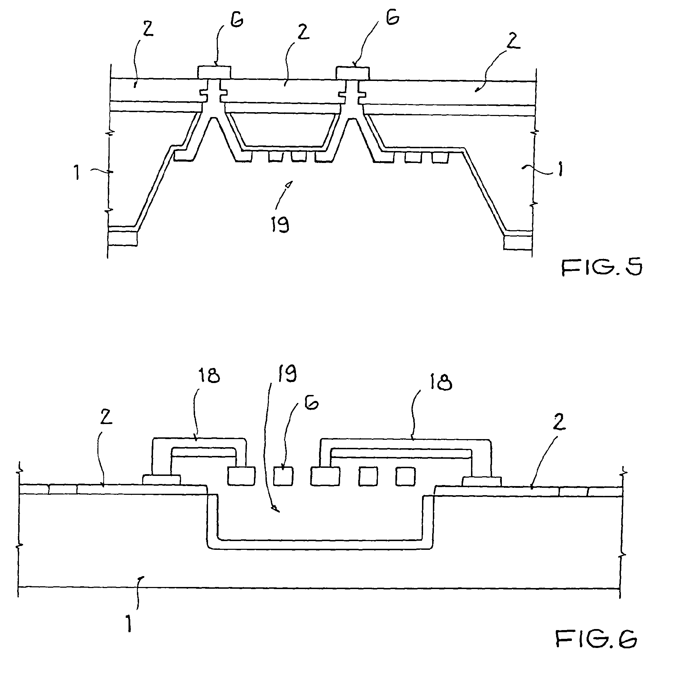

In Fig. 5 ist eine Induktivitätsstruktur gemäß einem weiteren Ansatz nach dem Stand der Technik illustriert. Hierbei wird von der Unterseite des Silizium-Substrates der Wafer gedünnt, um die Spiralspule platzsparend auf dem Wafer zu integrieren. Nachteilig hierbei ist, dass erhebliche Substratverluste auftreten.

Schließlich illustriert Fig. 6 einen weiteren Ansatz gemäß dem Stand der Technik für eine integrierte Induktivität. Dabei wird ein zurückgeätzter Bereich 19 in dem Substrat 1 unterhalb der Windungen 6 geätzt, wobei die Windungen 6 durch Überbrückungsmetallisierungen 18 über dem zurückgeätzten Bereich 19 getragen werden. Der zurückgeätzte Bereich 19 verringert die elektromagnetische Kopplung zwischen der Induktivität 6 und dem Substrat 1 und verringert die parasitäre Kapazität zwischen der Induktivität 6 und dem Silizium-Substrat 1, wodurch der Qualitätsfaktor und die Eigenresonanzfrequenz erhöht werden. Dieser zurückgeätzte Bereich 19 wird tief genug ausgebildet, so dass eventuell induzierte Wirbelströme verringert werden. Somit wird die gesamte Verlustleistung erheblich reduziert.

An diesem Ansatz gemäß dem Stand der Technik hat sich jedoch die Tatsache als nachteilig herausgestellt, dass der Herstellungsprozess sehr kompliziert, teuer und zeitaufwendig ist. Außerdem verbleibt eine parasitäre Kapazität zwischen den Metallisierungen 6 und dem Substrat 1 durch die Überbrückungsmetallisierungen 18. Zusätzlich müssen Verfahrensschritte zum Bilden dieser Brückenkonstruktion verwendet werden, welche ein reaktives Ionen-Ätzen (DRIE) und eine Abscheidung einer ca. 30 µm dicken Siliziumdioxid-Schicht beinhalten.

Somit ist es Aufgabe der vorliegenden Erfindung, ein Herstellungsverfahren für eine mikroabgeschirmte Spiralinduktivität und eine durch ein derartiges Herstellungsverfahren hergestelltes Bauelement mit einer Spiralinduktivität zu schaffen, welche die oben genannten Nachteile beseitigen und insbesondere ein einfacheres und kostengünstigeres Verfahren sowie ein Bauelement mit geringeren elektrischen Verlusten und einfacherer Erdung gewährleisten.

Diese Aufgabe wird erfindungsgemäß verfahrensseitig durch das Verfahren mit den Merkmalen gemäß Patentanspruch 1 und vorrichtungsseitig durch das Bauelement mit den Merkmalen gemäß Patentanspruch 22 gelöst.

Die der vorliegenden Erfindung zugrunde liegende Idee besteht darin, dass eine verbesserte Integration der einzelnen Metallisierungen und Windungen der Spiralinduktivität und eine direkte Verbindung der oberen und unteren Massemetallisierungen sowie eine auf einfache Weise hergestellte Verdikkung der Windungen der Spiralinduktivität durch folgende Schritte gewährleistet wird: Bilden einer strukturierten Induktivitätsmetallisierung und einer strukturierten oberen Massemetallisierung auf der Oberseite eines Substrats; Bilden einer zweiten dielektrischen Isolationsschicht zumindest zwischen der Induktivitätsmetallisierung und der oberen Massemetallisierung und über der Induktivitätsmetallisierung; vollständig Zurückätzen eines Bereiches des Substrates unterhalb der Induktivitätsmetallisierung derart, dass zumindest die Windungen der Induktivitätsmetallisierung vollständig durch Einbettung in die Isolationsschicht frei hängend über dem vollständig zurückgeätzten Bereich des Substrats getragen werden; und strukturiert Metallisieren der Oberfläche des zurückgeätzten Bereiches des Substrates zum Bilden einer gesamtverbundenen Massestelle und der sich über dem vollständig zurückgeätzten Bereich befindlichen Abschnitte der Induktivitätsmetallisierung zum Bilden von verdickten Windungen der Spiralinduktivität.

Somit wird durch ein einfaches und kostengünstiges Herstellungsverfahren eine Spiralinduktivität hergestellt, bei welcher die Windungen gegen äußere Einflüsse ohne zusätzlicher Abdeckung vollständig abgeschirmt und vollständig von dem Substrat derart entkoppelt sind, dass keine elektromagnetische Kopplung mit dem Substrat und somit zu anderen Bauelementen auftreten kann. Somit können Störungen, elektromagnetische Verluste, Substratverluste, etc. vermindert oder gänzlich beseitigt werden.

Ferner sind die oberen Massemetallisierungen direkt mit der unteren Massemetallisierung verbunden, so dass vorteilhaft lediglich ein einheitlicher Masseanschluss vorzusehen ist.

Zudem sind die Windungen der Spiralinduktivität auf einfache Weise dicker ausgebildet als bei einem Bauelement, welches nach dem Verfahren gemäß dem Stand der Technik hergestellt ist. Dies reduziert vorteilhaft die elektromagnetischen Verluste und den elektrischen Widerstand der Spiralinduktivität.

Zusätzlich ist das vorliegende Bauelement im Radiofrequenz- bzw. im Hochfrequenzbereich für siliziumbasierende Technologien für eine monolithische Integration der Spiralinduktivität geeignet. Somit wird insgesamt die Leistungsfähigkeit des Bauelementes erhöht, wobei dieses zusätzlich durch ein einfacheres Herstellungsverfahren kostengünstiger herstellbar ist, wie oben bereits erläutert.

In den Unteransprüchen finden sich weitere vorteilhafte Ausgestaltungen und Verbesserungen des im Patentanspruch 1 angegebenen Verfahrens und des im Anspruch 22 angegebenen Bauelementes.

Gemäß einer bevorzugten Weiterbildung wird eine zusätzliche Schicht, insbesondere eine erste dielektrische Isolationsschicht, auf der Oberseite des Substrates vor dem Bilden der Metallisierungen gebildet wird.

Gemäß einer weiteren bevorzugten Weiterbildung werden durch die strukturierte Metallisierung der Oberfläche des zurückgeätzten Bereiches des Substrates und der sich über dem vollständig zurückgeätzten Bereich befindlichen Abschnitte der einzelnen Metallisierungen von der Unterseite des Substrates her untere Massemetallisierungen gebildet, welche jeweils mit den sich über dem vollständig zurückgeätzten Bereich des Substrates befindlichen Abschnitten der entsprechenden oberen Massemetallisierungen verbunden werden. Somit erfolgt eine direkte Verbindung der oberen und unteren Masseleiter ohne einer nachteiligen dielektrischen Zwischenschicht. Dadurch kann insgesamt ein einheitlicher Masseanschluss erfolgen, was kostengünstig bewerkstelligt werden kann. Zusätzlich werden die Windungen der Spiralinduktivität durch die untere Metallisierung verdickt, so dass der elektrische Widerstand vorteilhaft verringert wird.

Vorteilhaft wird das vollständige Zurückätzen eines Bereiches des Substrates unterhalb der Windungen der Spiralinduktivität durch zwei aufeinanderfolgende Ätzschritte ausgeführt. Dabei besteht der erste Ätzschritt vorzugsweise darin, einen Bereich des Substrates unterhalb der Windungen der Spiralinduktivität derart teilweise zurückzuätzen, dass eine dünne Substratschicht unterhalb der Windungen zurückbleibt. In einem anschließenden zweiten Ätzschritt wird zum Bilden einer Stufenstruktur des zurückgeätzten Bereiches des Substrates unterhalb der Windungen ein Abschnitt der zuvor gebildeten dünnen Substratschicht mittels beispielsweise eines weiteren nasschemischen Ätzverfahrens vollständig zurückgeätzt. Somit wird eine höhere Integrationsdichte erreicht, wobei die nicht vollständig zurückgeätzten Abschnitte der zuvor gebildeten dünnen Substratschicht eine größere Stabilität der Substratoberfläche gewährleisten. Insbesondere kann der erste und der zweite Ätzschritt als nasschemisches Ätzverfahren ausgeführt werden. Bei dem zweiten Ätzschritt wird beispielsweise eine weitere (vierte) Isolationsschicht auf der Unterseite des Substrates und der Oberfläche des teilweise zurückgeätzten Abschnitts abgeschieden, wobei die vierte Isolationsschicht durch Entwickeln eines beispielsweise aufgedampften photoresistiven Materials geeignet strukturiert wird, um die gewünschte anisotrope vollständige Zurückätzung eines Abschnitts der zuvor gebildeten dünnen Substratschicht zu gewährleisten. Als abschließende Behandlungen können beispielsweise die photoresistive Schicht mittels einer geeigneten Lösung, beispielsweise Azeton, abgewaschen und die auf der Unterseite des Substrates verbliebenen Isolationsschichten mittels beispielsweise eines nasschemischen Ätzverfahrens oder eines Trockenätzverfahrens beseitigt werden.

Gemäß einem weiteren bevorzugten Ausführungsbeispiel wird ein weiteres Substrat mit geeigneter Geometrie zum Bilden eines Luftbereiches auf der Unterseite des prozessierten Substrates aufgebracht. Aufgrund der günstigen Dielektrizitätskonstanten von Luft erfolgt somit eine gute Abschirmung der Spiralinduktivität zum Substrat und zu weiteren benachbarten Bauteilen. Dadurch können Substratverluste und elektromagnetische Verluste verringert werden. Vorzugsweise ist das weitere Substrat mit einer Metallisierung an der Oberfläche ausgebildet, welche zumindest teilweise mit der unteren Massemetallisierung verbunden werden kann. Somit kann auch der Widerstand der unteren Masseleiter verringert und zusätzlich eine mechanisch stabile Verbindung geschaffen werden.

Vorzugsweise wird das weitere Substrat mit einer derartigen Geometrie ausgebildet, dass es zumindest teilweise in den teilweise zurückgeätzten Bereich formschlüssig eingesetzt werden kann. Somit entsteht wiederum ein gut abgeschirmter Hohlbereich und eine ausgezeichnete Entkopplung der Windungen der Spiralinduktivität von dem Substrat und von benachbarten Bauelementen. Zudem kann die Oberfläche des weiteren Substrates wiederum eine Metallisierung aufweisen, welche mit der unteren Massemetallisierung des prozessierten Substrates verbunden werden kann. Dadurch kann der elektrische Widerstand der Masseleitungen erheblich verringert und die Stabilität des gesamten Bauelementes vergrößert werden.

Nach einem weiteren bevorzugten Ausführungsbeispiel wird vor der strukturierten Metallisierung eine photoresistive Schicht bzw. ein Photolack auf der Oberfläche des zurückgeätzten Bereiches des Substrates gebildet und entsprechend beleuchtet bzw. entwickelt. Der Photolack stellt eine einfache Variante einer Maske für eine strukturierte Metallisierung des Substrates dar.

Vorzugsweise wird die zweite Isolationsschicht bereits bei ihrer Herstellung mit Überbrückungsöffnungen versehen, zwischen welchen eine Überbrückungsmetallisierung für eine Überbrückung mindestens eines Anschlusses der Spiralinduktivität gebildet wird.

Gemäß einem weiteren bevorzugten Ausführungsbeispiel wird eine Abdeckmetallisierung über der Spiralinduktivität bzw. der Induktivitätsmetallisierung ausgebildet, welche deckelförmig auf der oberen Massemetallisierung angebracht ist. Dadurch entsteht ein vollständig abgeschirmtes System und eine einheitliche Masseleitung für das gesamte System. Ferner wird die Spiralinduktivität vor äußeren Störeinflüssen und Verunreinigungen abgeschirmt.

Beispielsweise können mehrere Spiralinduktivitäten nebeneinander auf einem gemeinsamen Substrat vorgesehen werden, wobei das Substrat zum Bilden der jeweiligen Hohlbereiche und Metallisierungen gemeinsamen Verfahrensschritten unterzogen wird. Somit muss nicht jede einzelne Spiralinduktivität gesondert hergestellt werden, sondern es können alle Spiralinduktivitäten zusammen kostengünstig mittels gemeinsamer Verfahrensschritte erzeugt werden. Beispielsweise werden die jeweiligen Massemetallisierungen benachbarter Spiralinduktivitäten über den durch das strukturierte Metallisieren gebildeten unteren Masseleiter elektrisch miteinander verbunden. Somit genügt wiederum lediglich eine einheitliche Massestelle. Die Spiralinduktivität kann beispielsweise rechteckige oder runde Windungen oder dergleichen aufweisen.

Insbesondere ist das Substrat als Silizium-Halbleitersubstrat ausgebildet. Vorzugsweise bestehen die einzelnen Metallisierungen aus Aluminium, Kupfer, Silber, Gold, Titan, oder dergleichen.

Gemäß einem weiteren bevorzugten Ausführungsbeispiel werden die dielektrischen Isolationsschichten mit Ausnahme der Membran aus einem anorganischen Isolationsmaterial, beispielsweise einem Siliziumoxid, insbesondere Siliziumdioxid, Silizium mit eingeschlossenen Luftbereichen, Siliziumnitrid, oder dergleichen gebildet.

Die als Membran dienende dielektrische Isolationsschicht besteht vorteilhaft aus einem organischen Isolationsmaterial, beispielsweise einem organischen Polymer-Material, wie beispielsweise Benzozyclobuten (BCB), SiLK, SU-8, Polyimid, oder dergleichen.

Nachfolgend werden bevorzugte Ausführungsbeispiele der vorliegenden Erfindung unter Bezugnahme auf die Figuren der Zeichnung näher erläutert. Von den Figuren zeigen:
- Fig. 1: eine schematische Draufsicht auf eine Struktur einer Spiralinduktivität gemäß einem Ansatz nach dem Stand der Technik;
- Fig. 2: eine schematische Ansicht einer Struktur einer Spiralinduktivität gemäß einem weiteren Ansatz nach dem Stand der Technik;
- Fig. 3: eine schematische Draufsicht und eine Querschnittsansicht entlang der Linie A-A' einer integrierten Induktivität gemäß einem weiteren Ansatz nach dem Stand der Technik;
- Fig. 4: eine schematische Draufsicht auf eine Induktivität gemäß einem weiteren Ansatz nach dem Stand der Technik;
- Fig. 5: eine Querschnittsansicht einer Induktivitätsstruktur gemäß einem weiteren Ansatz nach dem Stand der Technik;
- Fig. 6: eine Querschnittsansicht einer Induktivitätsstruktur gemäß einem noch weiteren Ansatz gemäß dem Stand der Technik;
- Fig. 7a bis 7m: Querschittsansichten eines erfindungsgemäßen Bauelementes mit auf einem Substrat integrierter Induktivität in verschiedenen Verfahrenszuständen zur Darstellung der einzelnen Verfahrensschritte gemäß einem ersten Ausführungsbeispiel der vorliegenden Erfindung;
- Fig. 8: eine schematische Draufsicht des Bauelementes aus Fig. 7m gemäß dem ersten Ausführungsbeispiel der vorliegenden Erfindung;
- Fig. 9: eine Querschnittsansicht eines Bauelementes mit zwei auf einem Substrat integrierten Induktivitäten gemäß einem zweiten Ausführungsbeispiel der vorliegenden Erfindung;
- Fig. 10: eine Querschnittsansicht eines Bauelementes mit zwei auf einem Substrat angeordneten Induktivitäten gemäß einem dritten Ausführungsbeispiel der vorliegenden Erfindung; und
- Fig. 11: eine Querschnittsansicht eines Bauelementes mit zwei auf einem Substrat integrierten Induktivitäten gemäß einem vierten Ausführungsbeispiel der vorliegenden Erfindung.

In den Figuren bezeichnen gleiche Bezugszeichen gleiche oder funktionsgleiche Komponenten, soweit nichts Gegenteiliges angegeben ist.

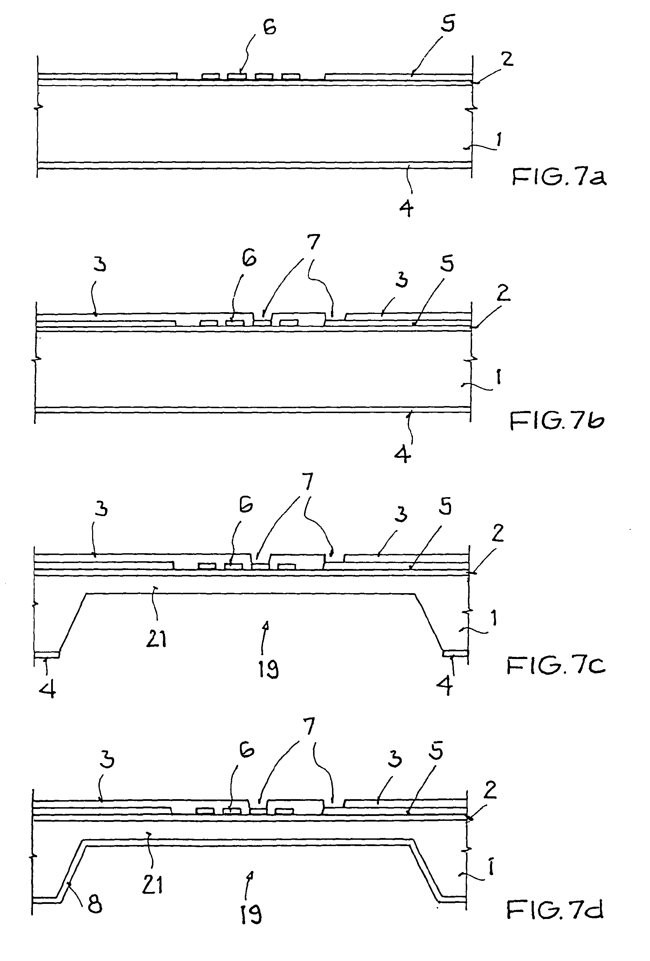

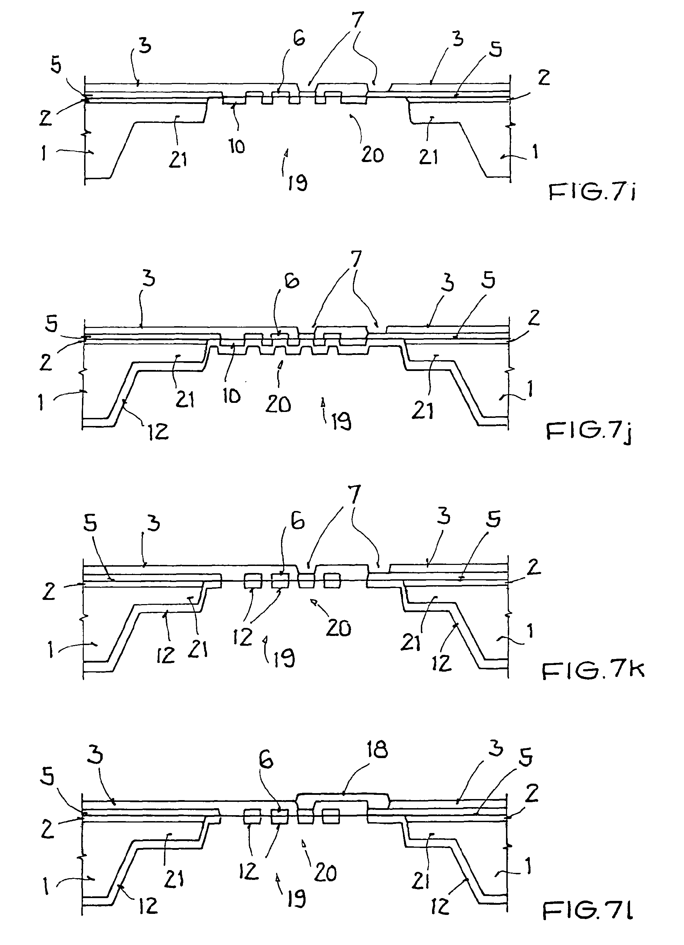

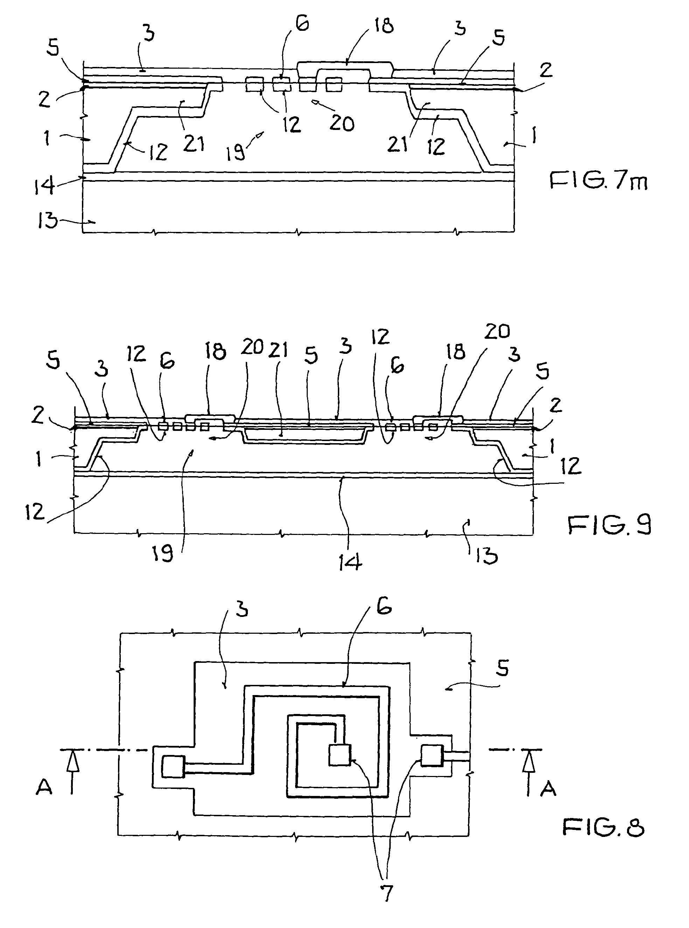

Die Figuren 7a bis 7m illustrieren Querschnittsansichten eines beispielhaften Bauelementes in ausgewählten Verfahrenszuständen, wobei anhand der Fig. 7a bis 7m ein Herstellungsverfahren eines Bauelementes, welches eine Spiralinduktivität auf einem Substrat aufweist, gemäß einem ersten Ausführungsbeispiel der vorliegenden Erfindung näher erläutert wird.

Wie in Fig. 7a ersichtlich ist, wird beispielsweise in einem bereits für die Herstellung von Metallisierungen bekannten Verfahrensschritt ein Substrat 1 auf seiner Oberseite und seiner Unterseite mit einer ersten Schicht, beispielsweise einer ersten dielektrischen Isolationsschicht 2 bzw. mit einer weiteren dielektrischen Isolationsschicht 4 (im folgenden als dritte Isolationsschicht 4 bezeichnet) versehen. Es kann jedoch auch auf die Schichten 2 und 4 unter bestimmten Umständen verzichtet werden. Das Substrat 1 ist beispielsweise ein niederohmiges Silizium-Halbleitersubstrat oder dergleichen. Die erste und dritte dielektrische Isolationsschicht 2 bzw. 4 kann jeweils beispielsweise als in etwa 1-2 µm dicke Siliziumnitrid- oder Siliziumdioxid-Schicht ausgebildet werden. Anschließend wird zur Bildung der Spiralinduktivität eine Induktivitätsmetallisierung 6 und eine obere Massemetallisierung 5 auf der ersten dielektrischen Isolationsschicht 2 mittels beispielsweise eines Standardmetallisierungsverfahrens aufgebracht. Die Induktivitätsmetallisierung 6 weist vorzugsweise rechteckige Windungen und zwei Anschlüsse auf. Als besonders geeignetes Material für die Metallisierungen 5 und 6 hat sich Aluminium herausgestellt. Jedoch können auch andere Materialien, wie beispielsweise Kupfer, Gold, Silber, Titan, oder dergleichen verwendet werden.

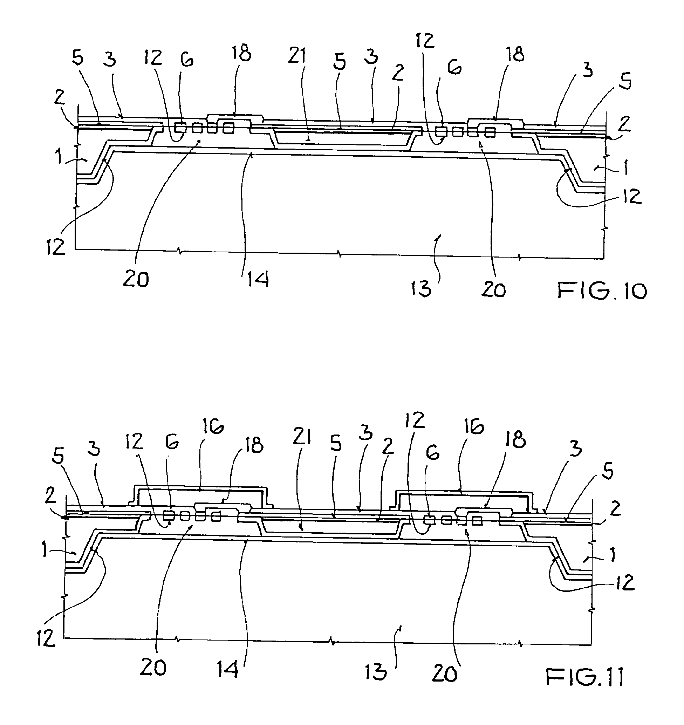

Nachfolgend, wie in Fig. 7b dargestellt ist, wird eine zweite dielektrische Isolationsschicht 3 über der ersten dielektrischen Isolationsschicht 2 und zumindest über der Induktivitätsmetallisierung 6 derart gebildet, dass die Induktivitätsmetallisierung 6 vollständig in der zweiten dielektrischen lsolationsschicht 3 eingebettet ist. Für ein besseres Verständnis wird gleichsam auf die Draufsicht in Fig. 8 verwiesen.

Die zweite dielektrische Isolationsschicht 3 dient als Trägermembran und ist vorzugsweise aus dem Material SU-8 hergestellt, welches beispielsweise auf die Oberseite des Substrates 1 geschleudert und anschließend zur Aushärtung einer Temperaturbehandlung unterzogen wird. SU-8 ist ein negativer Photolack bzw. negativer Photoresist, welcher ausgezeichnete Charakteristika für Hochfrequenzanwendungen aufweist. Es sei bereits an dieser Stelle darauf hingewiesen, dass es nach einer Bildung der SU-8-Schicht 3 auf der Oberfläche des Substrates 1 sehr schwierig ist, diese nach der Aushärtung wieder zu entfernen. Daher sollte die SU-8-Schicht 3 bereits an geeigneten Stellen für eventuell weitere Metallisierungen, insbesondere Überbrükkungsmetallisierungen, geeignet strukturiert und zurückgeätzt werden. Ein weiterer Vorteil des SU-8-Materials besteht darin, dass es stabil gegen anisotrope Ätzlösungen, wie beispielsweise einer KOH-Lösung, ist. Die zweite dielektrische als Membran dienende Isolationsschicht 3 kann beispielsweise auch aus einem weiteren organischen Isolationsmaterial, beispielsweise einem organischen Polymermaterial, insbesondere Benzozyclobuten (BCB), einem SiLK-Material, einem Polyimid, oder dergleichen hergestellt werden.

Nachfolgend erfolgt ein Zurückätzen des Substrates unterhalb der Spiralinduktivität stufenförmig durch zwei aufeinanderfolgende Substrat-Ätzvorgänge derart, dass unterhalb der Windungen der Induktivitätsmetallisierung 6 vorteilhaft ein stufenförmig zurückgeätzter Bereich gebildet wird. Dies wird im folgenden näher erläutert.

Zunächst wird, wie in Fig. 7c dargestellt ist, in einem ersten Substrat-Ätzschritt ein erster Bereich 19 des Substrates 1 derart teilweise zurückgeätzt, dass eine dünne Substratschicht 21 von etwa 20-30 µm unterhalb der Spiralinduktivität verbleibt. Dabei wird beispielsweise die dritte dielektrische Isolationsschicht 4 als geeignete Maske für diesen Ätzvorgang verwendet. Aufgrund der anisotropen Teilzurückätzung des Substrates 1 entsteht eine schräg ausgebildete Begrenzungsfläche des teilweise zurückgeätzten Bereiches 19.

Anschließend wird eine vierte dielektrische Isolationsschicht 8, wiederum beispielsweise aus Siliziumdioxid oder Siliziumnitrid bestehend, auf der Oberfläche des ersten zurückgeätzten Bereiches 19 unter Verwendung eines gängigen Abscheideverfahrens abgeschieden. Dies ist schematisch in Fig. 7d illustriert.

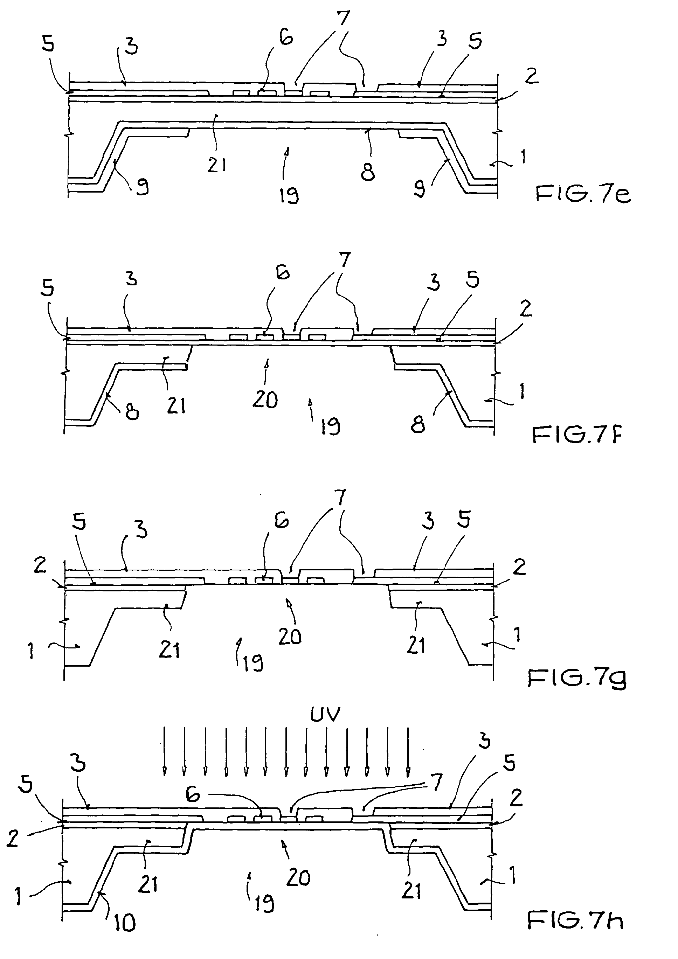

In einem anschließenden Verfahrensschritt gemäß Fig. 7e wird eine erste photoresistive Schicht 9, beispielsweise ein Photolack 9, als Maske aufgebracht und entwickelt.

Wie in Fig. 7f ersichtlich ist, wird die vorher auf die Oberfläche des ersten zurückgeätzten Bereichs 19 aufgebrachte vierte dielektrische lsolationsschicht 8 (siehe Fig. 7d) bzw. die dünne Substratschicht 21 unter Zuhilfenahme der Photomaske 9 unterhalb der Windungen der Induktivitätsmetallisierung 6 lediglich in einem Bereich 20 vollständig zurückgeätzt, welcher in etwa der Breitenausdehnung der Windungen der Induktivitätsmetallisierung 6 entspricht, wodurch die in Fig. 7f dargestellte Struktur erhalten wird.

Das vorzugsweise verwendete SU-8-Material ist dabei stabil gegenüber eines anisotropen Ätzmittels, wie beispielsweise einer-KOH-Lösung. Ferner dient die erste dielektrische Isolationsschicht 2 zudem als dielektrische Schutzschicht der Metallisierungen 5 und 6 vor dem KOH-Ätzmittel. Somit kann das Silizium-Substrat 1 unterhalb der Windungen der Spiralinduktivität auf einfache Weise mittels eines standardmäßigen KOH-Nassätzverfahrens zurückgeätzt werden, ohne die SU-8-Membran 3 oder die Metallisierungen 5 und 6 zu beschädigen.

Anschließend werden die verbliebenen Abschnitte der vierten dielektrischen Isolationsschicht 8 auf der Unterseite des Substrats 1 und der Bereich der ersten dielektrischen Isolationsschicht 2, welcher den vollständig zurückgeätzten Bereich 20 bedeckt, mittels beispielsweise eines Trocken-Ätzverfahrens entfernt. Dieser Schritt und die resultierende Struktur sind in Fig. 7g schematisch dargestellt.

Durch diese Stufenstruktur können geometrische Einschränkungen aufgrund der schräg zurückgeätzten Bereiche reduziert werden und benachbarte Spiralinduktivitäten näher benachbart zueinander angeordnet werden, ohne die mechanische Stabilität des gesamten Bauelementes zu verringern. Es können durch das vorstehend näher erläuterte Verfahren abschirmende Hohlbereiche unterhalb der Spiralinduktivität geschaffen werden, ohne die Oberfläche des Bauelementes mechanisch instabiler zu gestalten, so dass eine höhere Integrationsdichte vorteilhaft erzielt wird.

Es sei an dieser Stelle darauf hingewiesen, dass wiederum in sämtlichen Figuren eine einheitliche Orientierung des Bauelementes bzw. des Substrates 1 derart beibehalten wird, dass sich die Spiralinduktivität auf der Oberseite des Substrates 1 befindet. In der Praxis ist es allerdings vorteilhaft, das Substrat für die einzelnen Verfahrensschritte entsprechend günstig auszurichten, so dass mittels einer geeigneten Substrat-Trägereinrichtung ein Drehen des Substrates für die unterschiedlichen Verfahrensschritte bewerkstelligt werden kann.

Als nächstes wird, wie in Fig. 7h illustriert ist, ein Photolack 10, beispielsweise ein negativer Photolack 10, auf der Oberfläche der zurückgeätzten Bereiche 19 und 20 und der Unterseite des den vollständig zurückgeätzten Bereich 20 bedeckenden Abschnitt der SU-8-Schicht 3 von der Unterseite des Substrates 1 her mittels beispielsweise eines Schleuderverfahrens gebildet. Es ist für einen Fachmann offensichtlich, dass anstelle eines negativen Photolacks auch ein positiver Photolack mit entsprechenden Verfahrensschritten vice versa verwendet werden kann.

Wie ferner in Fig. 7h ersichtlich ist, wird die photoresistive Schicht 10, wie bei einem Photolithographie-Verfahren üblich, bestrahlt bzw. als Maske entwickelt. Beispielsweise kann das Bauelement von der Oberseite her mit ultraviolettem Licht bestrahlt werden. Selbstverständlich können bei geeigneten Materialien auch Elektroden-, Röntgen- oder Ionen-Strahlungen als Belichtungsmedium verwendet werden. Durch eine derartige Belichtung werden bei einem negativen Photolack Bindungen von Makromolekülen aufgebrochen oder kleinere Moleküle polymerisiert, wodurch sie bei einer anschließenden Behandlung als Rückstand strukturiert zurückbleiben und nicht von dem Bauelement entfernt werden.

Anschließend erfolgt eine Entwicklung des negativen Photolacks 10 derart, dass die belichteten Bereiche weiterhin an der Unterseite der Membran 3 unterhalb der Zwischenbereiche zwischen den einzelnen Metallisierungsabschnitten anhaften, während die nicht belichteten Bereiche entfernt werden. Die nicht belichteten Abschnitte des negativen Photolacks 10 werden beispielsweise mittels einer KOH-Lösung entfernt. Dadurch wird die in Fig. 7i dargestellte Struktur erhalten.

In einem anschließenden Verfahrensschritt gemäß Fig. 7j wird die Unterseite des Substrates 1 bzw. der zurückgeätzten Bereiche 19 und 20 einer Rückmetallisierung bzw. einer Aufbringung einer unteren Metallisierung 12 unterzogen. Dadurch entsteht die in Fig. 7j dargestellte Struktur, wobei Abschnitte der unteren Metallisierung jeweils direkt mit den oberen Masseleitern 5 ohne einer dielektrischen Zwischenschicht vorteilhaft verbindbar sind.

Ferner ist aus Fig. 7j ersichtlich, dass die Windungen der Induktivitätsmetallisierung 6 durch die zusätzliche untere Metallisierung 12 mittels eines Standard-Metallisierungsverfahrens verdickt ausgebildet werden können, wodurch der elektrische Widerstand der Windungen vorteilhaft verringert wird.

Nachfolgend werden mittels eines geeigneten Verfahrens, beispielsweise mittels eines Abwaschvorgangs unter Zuhilfenahme einer Azeton-Lösung, die verbliebenen Abschnitte des negativen Photolacks 10 und der darauf abgeschiedenen Metallabschnitte 12 geeignet entfernt, wie in Fig. 7k ersichtlich ist. Somit wird die in Fig. 7k dargestellte Struktur erhalten.

Anschließend wird vorzugsweise der innere Anschluss der Spiralinduktivität über eine Überbrückungsmetallisierung 18 an einen vorgesehenen Spannungsanschluss elektrisch verbunden, wie in Fig. 7I illustriert ist. Die vorzugsweise vorab (siehe Erläuterung bzgl. Fig. 7b) in der SU-8-Membran 3 erzeugten Überbrückungsöffnungen 7 werden dazu strukturiert durch eine Überbrückungsmetallisierung 18 miteinander verbunden, so dass ein elektrischer Anschluss des inneren Windungsendes der Induktivitätsmetallisierung 6 mit einer äußeren Anschlussleitung hergestellt wird. Die Überbrückungsmetallisierung 18 kann vorzugsweise durch ein Standard-Metallisierungsverfahren hergestellt werden, wobei für das Material die bereits oben genannten vorteilhaften Materialien Verwendung finden.

Schließlich wird vorzugsweise ein weiteres Substrat 13 auf die Unterseite des prozessierten Substrates 1 derart aufgebracht, dass ein vollständig abgeschlossener Hohlbereich bzw. Abschirmungsbereich 19, 20 entsteht. Wie in Fig. 7m dargestellt ist, wird das zusätzliche Substrat 13, welches beispielsweise ebenfalls als Silizium-Substrat ausgebildet ist, auf der Oberseite mit einer Metallisierung 14 versehen, wodurch die untere Metallisierung 12 zumindest teilweise verdickt ausgebildet wird. Das weitere Substrat 13 kann beispielsweise durch diesen zusätzlich vorgesehenen elektrischen Leiter mit dem prozessierten Substrat 1 bzw. der an der Unterseite dieses Substrates 1 vorgesehenen Massemetallisierung 12 verbunden werden. Alternativ kann eine Verbindung auch durch Tempern bzw. eine Wärmebehandlung oder durch eine Mikrowellenbehandlung bewerkstelligt werden.

Somit müssen die einzelnen Induktivitätsmetallisierungen nicht getrennt voneinander hergestellt und anschließend mittels beispielsweise einer "Flip-Chip-Technologie" miteinander verbunden werden, sondern können in einem einheitlichen und somit kostengünstigeren Verfahren gemeinsam auf einem Substrat hergestellt werden.

Fig. 8 illustriert eine schematische Ansicht einer Schnittebene der Spiralinduktivität aus Fig. 7m, wobei Fig. 7m eine Querschnittsansicht entlang der Linie A-A in Fig. 8 darstellt. Wie in Fig. 8 ersichtlich ist, ist die obere Massemetallisierung 5 vorzugsweise durch die aufgebrachte SU-8-Membran 3 von der Induktivitätsmetallisierung 6 elektrisch getrennt. Gemäß dem vorliegenden Ausführungsbeispiel ist die Induktivitätsmetallisierung 6 mit rechteckigen Windungen ausgebildet. Es ist für einen Fachmann offensichtlich, dass eine andere Windungsform, beispielsweise runde Windungen, ebenfalls denkbar sind.

In Fig. 8 sind ferner die Überbrückungsöffnungen 7 für eine Überbrückungsmetallisierung schematisch dargestellt, wodurch das innere Windungsende durch die Überbrückungsmetallisierung mit einem äußeren Anschluss verbindbar ist.

Wie eingangs bereits erläutert, sollte vorzugsweise am Anfang des Herstellungsprozesses beim Erzeugen der zweiten dielektrischen Schicht bzw. der Membran 3 diese mit entsprechenden Strukturierungen für weitere Metallisierungen ausgebildet werden, da eine nachträgliche Bearbeitung der ausgehärteten Membran 3 schwer zu bewerkstelligen ist.

Fig. 9 illustriert eine Querschnittsansicht eines Bauelementes gemäß einem zweiten Ausführungsbeispiel der vorliegenden Erfindung. Das Bauelement besteht beispielsweise aus zwei benachbart zueinander angeordneten Spiralinduktivitäten, welche durch gemeinsame Verfahrensschritte gemäß dem ersten Ausführungsbeispiel gleichzeitig auf dem gemeinsamen Substrat 1 hergestellt werden. Wie ersichtlich, weist das hergestellte Bauelement aufgrund der Stufenstruktur und der zwischen den beiden benachbart zueinander angeordneten Spiralinduktivitäten vorgesehenen dünnen Substratschicht 21 einen mechanisch stabilen Aufbau auf.

Vorzugsweise ist nach einem dritten Ausführungsbeispiel der vorliegenden Erfindung gemäß Fig. 10 das zweite Substrat 13 im Unterschied zum ersten und zweiten Ausführungsbeispiel mit einer derartigen Geometrie ausgebildet, dass es in etwa formschlüssig in den ersten zurückgeätzten Bereich 19 eingesetzt werden kann. Dadurch wird eine äußerst kompakte Bauform realisiert, in welcher nach wie vor einer Entkopplung dienende Luftbereiche 20 unterhalb des jeweiligen Spiralinduktivität vorgesehen sind.

Vorzugsweise wird die Oberfläche des zweiten Substrats 13 ebenfalls mit einer Metallisierung 14 versehen, welche mit der unteren Metallisierung 12 des prozessierten Substrats 1 zumindest teilweise fest verbunden wird. Dadurch erhält man zusätzlich eine einheitliche elektrische Verbindung sämtlicher Massemetallisierungen 5, 12, so dass lediglich ein gemeinsamer Masseanschluss vorgesehen werden muss.

Wie in Fig.10 ersichtlich ist, sind die beiden benachbarten Spiralinduktivitäten wiederum durch eine dünne Substratschicht 21 voneinander getrennt, wodurch ein mechanisch stabiler Aufbau erreicht wird. Ferner wird durch das formschlüssige Einsetzen des weiteren Substrates 13 in den ersten zurückgeätzten Bereich 19 die dünne Substratschicht 21 zwischen den beiden benachbarten Spiralinduktivitäten zusätzlich abgestützt, so dass insgesamt die mechanische Stabilität des Bauelementes erheblich verbessert wird.

Fig. 11 illustriert eine Querschnittsansicht eines Bauelementes gemäß einem vierten Ausführungsbeispiel der vorliegenden Erfindung. Wie in Fig. 11 ersichtlich ist, wird zusätzlich eine Abdeckmetallisierung 16 über der Spiralinduktivität gebildet, wobei die Randbereiche der Abdeckmetallisierung 16 jeweils mit der oberen Massemetallisierung verbunden sind. Die Abdeckmetallisierung 16 kann unter Verwendung einer dicken weiteren photoresistiven Schicht auf der Oberseite des bisherigen Bauelementes abgeschieden werden. Dazu wird nach einer Strukturierung der SU-8-Membran 3 (vorzugsweise wiederum bei Aufbringung der SU-8-Schicht) eine dicke photoresistive Schicht, beispielsweise ca. 30 µm dick, auf der zweiten dielektrischen Isolationsschicht 3 abgeschieden und strukturiert. Vorzugsweise können die scharfen Ecken des weiteren photoresistiven Materials unter Verwendung beispielsweise eines Sauerstoff-Plasma-Ätzverfahrens geglättet werden. Danach kann mittels eines Standard-Metallisierungsverfahrens die Form der Abdeckmetallisierung als Abdeckung vor äußeren Verunreinigungen und Störeinflüssen gebildet werden.

Somit entsteht ein abgeschlossenes System für einen zusätzlichen Schutz der Spiralinduktivität vor äußeren Störeinflüssen und Verunreinigungen. Ferner ist somit die Abdeckmetallisierung 16 für eine gemeinsam elektrische Verbindung sämtlicher Massemetallisierungen angeordnet, so dass lediglich ein gemeinsamer Masseanschluss vorgesehen werden muss.

Es sei an dieser Stelle darauf hingewiesen, dass die charakteristischen Merkmale der Bauteile der einzelnen Ausführungsbeispiele beliebig miteinander kombiniert werden können, so dass ein dem jeweiligen Anwendungsfall spezifisch entwickeltes Bauelement geschaffen wird.

Obwohl die vorliegende Erfindung anhand bevorzugter Ausführungsbeispiele vorstehend beschrieben wurde, ist sie darauf nicht beschränkt, sondern auf vielfältige Weise modifizierbar.

Beispielsweise können andere Materialien für die einzelnen Metallisierungen, für das Substrat und für die einzelnen dielektrischen Isolationsschichten verwendet werden. Ferner können andersartige gängige Verfahren zur Strukturierung, Rückätzung des Substrates, Entfernung rückständiger Beschichtungen, etc eingesetzt werden. Selbstverständlich können beliebig viele Spiralinduktivitäten entsprechend der zur Verfügung stehenden Substratfläche benachbart zueinander vorgesehen werden.

Somit schafft die vorliegende Erfindung ein Bauelement mit einer Spiralinduktivität und ein Herstellungsverfahren für ein derartiges Bauelement, welches im Vergleich zu bekannten Herstellungsverfahren mit einem geringeren Aufwand ausführbar ist. Gemäß der vorliegenden Erfindung sind für die Herstellung der Membrane keine Masken für Photolithographie-Prozesse notwendig. Ferner können Standardverfahren und gemeinsame Verfahrensschritte für mehrere benachbart zueinander angeordneten Spiralinduktivitäten ausgeführt werden, wobei ein gegenüber dem Stand der Technik stabileres Bauelement mit einer größeren Integrationsdichte geschaffen wird. Somit ist das vorliegende Herstellungsverfahren einfacher, schneller und kostengünstiger.

Zudem kann auf einfache Weise durch das vorliegende Herstellungsverfahren ein Bauelement geschaffen werden, bei welchem sämtliche Massemetallisierungen derart direkt miteinander verbunden sind, so dass lediglich eine einzige Anschlussstelle für eine Erdung notwendig ist. Ferner wird durch die einheitliche Verbindung sämtlicher Massemetallisierungen ein einheitlicher Masseanschluss gewährleistet, wodurch keine Potentialunterschiede der einzelnen Massemetallisierungen auftreten. Dadurch können weitere Verluste aufgrund von etwaigen Stromflüssen bei Potentialunterschieden verschiedener Massemetallisierungen verhindert werden. Zusätzlich werden die Windungen der Spiralinduktivität auf einfache Weise dicker ausgebildet, so dass der elektrische Widerstand der Windungen verringert wird.

Das Herstellungsverfahren der vorliegenden Erfindung eignet sich zur Herstellung von mehreren Spiralinduktivitäten auf einem gemeinsamen Substrat und in integrierten Schaltungen, insbesondere im Hochfrequenzbereich, da das Substrat trotz Schaffung von Entkopplungs-Luftbereichen unterhalb der Spiralinduktivität eine stabile Struktur aufweist. Diese Struktur liefert den Vorteil, dass die Windungen der Spiralinduktivität vollständig frei über dem Hohlbereich bzw. dem zurückgeätzten Bereich 20 durch Einbettung in die SU-8-Membran 3 hängt, so dass eine vollständige Entkopplung von dem Substrat gewährleistet wird. Die Massemetallisierungen können ebenfalls durch Einbettung in die Membran zumindest teilweise über den zurückgeätzten Bereichen getragen und somit von benachbarten Bauteilen weitestgehend entkoppelt werden.

Somit wird eine auf einem Substrat integrierte Induktivität auf einfache Weise, kostengünstig und zuverlässig geschaffen, welche gegenüber dem Stand der Technik einen erhöhten Qualitätsfaktor und eine erhöhte Eigenresonanzfrequenz aufweist. Ferner, wie oben bereits erläutert, werden die Verlustleistungen erheblich verringert bzw. gänzlich beseitigt, da für eine Entkopplung der Spiralinduktivität von dem Substrat selbst durch den zurückgeätzten Bereich des Substrates erfolgt. Dennoch wird durch das erfindungsgemäße Verfahren die mechanische Stabilität des Bauelementes gewährleistet, obwohl ein großer Freibereich unterhalb der Spiralinduktivität in dem Substrat vorhanden ist. Durch diesen zurückgeätzten Freibereich werden Wirbelströme in den Masseebenen verhindert, so dass keine Potentialschwankungen auftreten.

Ferner wird durch die Verwendung der organischen dielektrischen Isolationsschicht 3 und der Verwendung von zwei aufeinander folgenden Substrat-Ätzschritten eine flexible Verbindung der Membran und des Silizium-Substrates geschaffen. Dies resultiert in einer höheren mechanischen Stärke im Vergleich zu anderen Herstellungsverfahren gemäß dem Stand der Technik, welche bisher Membrane verwendeten, welche aus einem Drei-Schicht-Aufbau aus SiO₂-Si₃N₄-SiO₂ bestehen.

### Bezugszeichenliste

- 1: Substrat
- 2: erste dielektrische Isolationsschicht
- 3: zweite dielektrische Isolationsschicht (SU-8-Membran)
- 4: dritte dielektrische Isolationsschicht
- 5: obere Massemetallisierung
- 6: Induktivitätsmetallisierung
- 7: Überbrückungsöffnung
- 8: vierte dielektrische Isolationsschicht
- 9: erste photoresistive Schicht
- 10: zweite photoresistive Schicht
- 12: untere Massemetallisierung
- 13: weiteres Substrat
- 14: Metallisierung des weiteren Substrats
- 16: Abdeckmetallisierung
- 18: Überbrückungsmetallisierung
- 19: erster zurückgeätzter Bereich
- 20: zweiter zurückgeätzter Bereich
- 21: dünne Substratschicht

## Patentansprüche

1. Verfahren zur Herstellung einer Spiralinduktivität (6, 18) auf einem Substrat (1) mit folgenden Verfahrensschritten:
- Bilden einer strukturierten Induktivitätsmetallisierung (6) und einer strukturierten oberen Massemetallisierung (5) auf der Oberseite eines Substrates (1);
- Bilden einer Isolationsschicht (3) zumindest zwischen der Induktivitätsmetallisierung (6) und der oberen Massemetallisierung (5) und über der Induktivitätsmetallisierung (6);
- vollständig Zurückätzen eines Bereiches (19, 20) des Substrates (1) unterhalb der Induktivitätsmetallisierung (6) derart, dass zumindest die Windungen der Induktivitätsmetallisierung (6) vollständig durch Einbettung in die Isolationsschicht (3) frei hängend über dem vollständig zurückgeätzten Bereich (19, 20) des Substrats (1) getragen werden; und
- strukturiert Metallisieren der Oberfläche des zurückgeätzten Bereiches (19, 20) des Substrates (1) zum Bilden einer gesamtverbundenen Massestelle und der sich über dem vollständig zurückgeätzten Bereich (20) befindlichen Abschnitte der Induktivitätsmetallisierung (6, 18) zum Bilden von verdickten Windungen der Spiralinduktivität (6, 18).

2. Verfahren nach Anspruch 1,
**dadurch gekennzeichnet,**
**dass** eine zusätzliche Schicht (2), insbesondere eine erste dielektrische Isolationsschicht (2), auf der Oberseite des Substrates (1) vor dem Bilden der Metallisierungen (5, 6) gebildet wird.

3. Verfahren nach Anspruch 1 oder 2,
**dadurch gekennzeichnet,**
**dass** das vollständige Zurückätzen eines Bereiches (19, 20) des Substrates (1) unterhalb der Induktivitätsmetallisierung (6, 18) durch zwei aufeinanderfolgende Substrat-Ätzschritte ausgeführt wird, wobei in einem ersten Ätzschritt ein Bereich (19) des Substrates (1) unterhalb der Induktivitätsmetallisierung (6, 18) zum Bilden einer dünnen Substratschicht (21) unterhalb der Induktivitätsmetallisierung (6) teilweise zurückgeätzt und in einem anschließenden zweiten Ätzschritt ein Abschnitt (20) der dünnen Substratschicht (21) unterhalb der Induktivitätsmetallisierung (6, 18) zum Bilden einer Stufenstruktur des zurückgeätzten Bereiches (19, 20) des Substrates (1) vollständig zurückgeätzt wird.

4. Verfahren nach Anspruch 3,
**dadurch gekennzeichnet,**
**dass** der erste Ätzschritt als nasschemisches Ätzverfahren ausgeführt wird.

5. Verfahren nach einem der Ansprüche 3 oder 4,
**dadurch gekennzeichnet,**
**dass** der zweite Ätzschritt ein Abscheiden einer weiteren Isolationsschicht (8) auf der Unterseite des Substrates (1) und der Oberfläche des teilweise zurückgeätzten Abschnitts (19) und ein Strukturieren der weiteren Isolationsschicht (8) mittels Entwickeln eines beispielsweise aufgedampften Photolacks (9) zum strukturierten anisotropen vollständigen Zurückätzen eines Abschnitts (20) der dünnen Substratschicht (21) beinhaltet.

6. Verfahren nach Anspruch 5,
**dadurch gekennzeichnet,**
**dass** der Photolack (9) anschließend in geeigneter Weise entfernt wird.

7. Verfahren nach Anspruch 6,
**dadurch gekennzeichnet,**
**dass** die verbliebene weitere Isolationsschicht (8) mittels beispielsweise eines Trockenätzverfahrens vor dem Aufbringen des Photolacks (9) zum strukturierten Metallisieren entfernt wird.

8. Verfahren nach wenigstens einem der Ansprüche 2 bis 6,
**gekennzeichnet durch**
den zusätzlichen Schritt des Entfernens der ersten Isolationsschicht (2) im Abschnitt des zurückgeätzten Bereiches (19) des Substrates (1) mittels beispielsweise eines Trockenätzverfahrens vor dem Aufbringen des Photolacks (9) zum strukturierten Metallisieren.

9. Verfahren nach wenigstens einem der vorhergehenden Ansprüche,
**dadurch gekennzeichnet,**
**dass** durch die strukturierte Metallisierung eine untere Massemetallisierung (12) gebildet wird, welche jeweils mit einem sich über dem vollständig zurückgeätzten Bereich (20) des Substrates (1) befindlichen Abschnitt der oberen Massemetallisierung (5) verbunden wird.

10. Verfahren nach wenigstens einem der vorhergehenden Ansprüche,
**dadurch gekennzeichnet,**
**dass** ein weiteres Substrat (13) mit geeigneter Geometrie zum Bilden eines Hohlbereiches (19, 20) auf der Unterseite des Substrates (1) aufgebracht wird.

11. Verfahren nach Anspruch 10,
**dadurch gekennzeichnet,**
**dass** das weitere Substrat (13) mit einer Metallisierung (14) an der Oberfläche ausgebildet wird, welche zumindest teilweise mit der unteren Massemetallisierung (12) verbunden wird.

12. Verfahren nach einem der Ansprüche 10 oder 11,
**dadurch gekennzeichnet,**
**dass** das weitere Substrat (13) mit einer derartigen Geometrie ausgebildet wird, dass es zumindest teilweise in den teilweise zurückgeätzten Bereich (19) formschlüssig eingesetzt werden kann.

13. Verfahren nach wenigstens einem der vorhergehenden Ansprüche,
**dadurch gekennzeichnet,**
**dass** vor der strukturierten Metallisierung eine photoresistive Schicht (10) auf der Oberfläche des zurückgeätzten Bereiches (19) des Substrates (1) gebildet und entsprechend beleuchtet bzw. entwickelt wird.

14. Verfahren nach wenigstens einem der vorhergehenden Ansprüche,
**dadurch gekennzeichnet,**
**dass** die zweite Isolationsschicht (3) mit Überbrückungsöffnungen (7) für eine Überbrückung mindestens eines Anschlusses der Spiralinduktivität (6, 18) ausgebildet wird.

15. Verfahren nach Anspruch 14,
**dadurch gekennzeichnet,**
**dass** eine Überbrückungsmetallisierung (18) zwischen den Überbrükkungsöffnungen (7) gebildet wird.

16. Verfahren nach wenigstens einem der vorhergehenden Ansprüche,
**dadurch gekennzeichnet,**
**dass** eine Abdeckmetallisierung (16) über der Induktivitätsmetallisierung (6, 18) mittels einer photoresistiven Schicht ausgebildet wird, welche deckelförmig auf der oberen Massemetallisierung (5) angebracht wird.

17. Verfahren nach wenigstens einem der vorhergehenden Ansprüche,
**dadurch gekennzeichnet,**
**dass** mehrere Spiralinduktivitäten nebeneinander auf dem Substrat (1) vorgesehen werden, wobei das Substrat (1) zum Bilden der jeweils vollständig zurückgeätzten Bereiche (19, 20) unterhalb der jeweiligen Spiralinduktivität gemeinsamen Substrat-Ätzschritten unterzogen wird.

18. Verfahren nach wenigstens einem der vorhergehenden Ansprüche,
**dadurch gekennzeichnet,**
**dass** das Substrat (1) als Silizium-Halbleitersubstrat ausgebildet wird.

19. Verfahren nach wenigstens einem der Ansprüche 2 bis 18,
**dadurch gekennzeichnet,**
**dass** die Isolationsschicht (2) aus einem dielektrischen anorganischen Isolationsmaterial, beispielsweise einem Siliziumoxid, wie insbesondere Siliziumdioxid, Silizium mit Luftbereichen, Siliziumnitrid, oder dergleichen hergestellt wird.

20. Verfahren nach wenigstens einem der vorhergehenden Ansprüche,
**dadurch gekennzeichnet,**
**dass** die Isolationsschicht (3) als dielektrische Membran, bestehend aus einem organischen Isolationsmaterial, beispielsweise einem organischen Polymer-Material, wie insbesondere Benzozyclobuten (BCB), SU-8, SiLK, einem Polyimid, oder dergleichen hergestellt wird.

21. Verfahren nach wenigstens einem der vorhergehenden Ansprüche,
**dadurch gekennzeichnet,**
**dass** die Metallisierungen (5, 6, 12, 16, 18) aus Aluminium, Kupfer, Silber, Gold, Titan, oder dergleichen ausgebildet werden.

22. Bauelement mit:
- einem Substrat (1), welches einen von der Unterseite her vollständig zurückgeätzten Bereich (19, 20) aufweist;
- einer Isolationsschicht (3), welche oberhalb des Substrats (1) vorgesehen ist und den vollständig zurückgeätzten Bereich (20) überdeckt;
- einer oberen strukturierten Massemetallisierung (5);
- mindestens einer strukturierten Induktivitätsmetallisierung (6), deren Windungen vollständig durch Einbettung in der Isolationsschicht (3) über dem vollständig zurückgeätzten Bereich (20) des Substrates (1) für eine Entkopplung von demselben frei hängen; und mit
- einer von der Unterseite des Substrates (1) aufgebrachten unteren Metallisierung (12) auf der Oberfläche des zurückgeätzten Bereiches (19, 20) des Substrates (1) zum Bilden einer gesamtverbundenen Massestelle und auf den sich über den vollständig zurückgeätzten Bereichen (20) befindlichen Abschnitten der Spiralinduktivität (6, 18) zum Bilden von verdickten Windungen der Spiralinduktivität (6).

23. Bauelement nach Anspruch 22,
**dadurch gekennzeichnet,**
**dass** ein weiteres Substrat (13) mit geeigneter Geometrie zum Bilden eines Hohlbereiches (19, 20) auf der Unterseite des Substrates (1) anbringbar ist.

24. Bauelement nach Anspruch 23,
**dadurch gekennzeichnet,**
**dass** das weitere Substrat (13) mit einer Metallisierung an der Oberfläche ausgebildet ist, welche zumindest teilweise mit der unteren Metallisierung (12) verbindbar ist.

25. Bauelement nach Anspruch 23 oder 24,
**dadurch gekennzeichnet,**
**dass** das weitere Substrat (13) mit einer derartigen Geometrie ausgebildet ist, dass es zumindest teilweise in den zurückgeätzten Bereichen (19, 20) formschlüssig einsetzbar ist.

26. Bauelement nach wenigstens einem der Ansprüche 22 bis 25,
**dadurch gekennzeichnet,**
**dass** Überbrückungsöffnungen (7) in der zweiten Isolationsschicht (3) für eine Überbrückung mindestens eines Anschlusses der Spiralinduktivität (6) vorgesehen sind.

27. Bauelement nach Anspruch 26,
**dadurch gekennzeichnet,**
**dass** eine Überbrückungsmetallisierung (18) zwischen den Überbrükkungsöffnungen (7) vorgesehen ist.

28. Bauelement nach wenigstens einem der Ansprüche 22 bis 27,
**dadurch gekennzeichnet,**
**dass** eine Abdeckmetallisierung (16) über der Spiralinduktivität (6) mittels einer photoresistiven Schicht ausgebildet ist, welche deckelförmig auf der oberen Massemetallisierung (5) angebracht ist.

29. Bauelement nach wenigstens einem der Ansprüche 22 bis 28,
**dadurch gekennzeichnet,**
**dass** mehrere Spiralinduktivitäten (6, 18) nebeneinander auf dem Substrat (1) vorgesehen sind, wobei das Substrat (1) zum Bilden der jeweils vollständig zurückgeätzten Bereiche (19, 20) unterhalb der jeweiligen Spiralinduktivität (6, 18) gemeinsamen Substrat-Ätzschritten unterzogen wird.

30. Bauelement nach wenigstens einem der Ansprüche 22 bis 29,
**dadurch gekennzeichnet,**
**dass** das Substrat (1) als Silizium-Halbleitersubstrat ausgebildet ist.

31. Bauelement nach wenigstens einem der Ansprüche 22 bis 30,
**dadurch gekennzeichnet,**
**dass** die Isolationsschicht (2) aus einem dielektrischen anorganischen Isolationsmaterial, beispielsweise ein Siliziumoxid, wie insbesondere Siliziumdioxid, Siliziumnitrid, Silizium mit Lufteinschlüssen, oder dergleichen hergestellt ist.

32. Bauelement nach wenigstens einem der Ansprüche 22 bis 31,
**dadurch gekennzeichnet,**
**dass** die Isolationsschicht (3) als Membran, bestehend aus einem dielektrischen organischen Isolationsmaterial, beispielsweise einem organischen Polymer-Material, wie insbesondere Benzozyclobuten (BCB), SU-8, SiLK, einem Polyimid, oder dergleichen hergestellt ist.

33. Bauelement nach wenigstens einem der Ansprüche 22 bis 32,
**dadurch gekennzeichnet,**
**dass** die Metallisierungen (5, 6, 12, 16, 18) aus Aluminium, Kupfer, Silber, Gold, Titan, oder dergleichen ausgebildet sind.
